# EUROPÄISCHE PATENTSCHRIFT

(11) **EP 0 293 464 B1**
(45) Veröffentlichungstag und Bekanntmachung des Hinweises auf die Patenterteilung: **01.06.1994**
(21) Anmeldenummer: 88900888.4
(22) Anmeldetag: 21.12.1987
(51) Int. Cl.: H03J 7/18, H04H 1/00

(54) **VERFAHREN ZUM ÜBERTRAGEN UND/ODER ZUM EMPFANGSSEITIGEN AUSWERTEN ZUSÄTZLICHER INFORMATIONEN INNERHALB EINES RUNDFUNKSIGNALS**
PROCESS FOR TRANSMITTING AND/OR EVALUATING ON THE RECEIVER SIDE INFORMATION INSIDE A RADIO SIGNAL
PROCEDE POUR TRANSMETTRE ET/OU EVALUER COTE RECEPTION DES INFORMATIONS A L'INTERIEUR D'UN SIGNAL RADIO

(30) Priorität: 19.12.1986 DE 3643617; 31.07.1987 DE 3725487; 05.06.1987 DE 3718845
(43) Veröffentlichungstag der Anmeldung: 07.12.1988
(60) Teilanmeldung: 93116790.2
(73) Patentinhaber: Thomson Consumer Electronics Sales GmbH, 30453 Hannover (DE)
(72) Erfinder: EINSEL, Robert, D-3100 Celle (DE); SCHARN, Günter, D-3257 Bennigsen (DE); SCHWAIGER, Karl-Heinz, D-8044 Lohhof (DE)
(74) Vertreter: Konle, Tilmar, Dipl.-Ing.
(86) Internationale Anmeldenummer: EP8700814
(87) Internationale Veröffentlichungsnummer: WO8804862

(56) Entgegenhaltungen:
- DE-A- 3 034 155
- DE-A- 3 222 025
- DE-A- 3 432 848
- DE-A- 3 448 043
- Rundfunktechnische Mitteilungen, vol. 30, No.3, May/June 1986, (München, DE), J. Mielke et al.:"Radio-Daten-System-RDS - Gegenwärtiger Entwicklungsstand und Versuchsergebnisse", p. 101-108.
- European Broadcasting Union, Tech. 3244-E, March 1984, (Brüssel, BE). "Specifications of the radio data system RDS for VHF/FM sound broadcasting", pages 1-59

## Beschreibung

Die Erfindung bezieht sich auf ein Verfahren gemäß dem Oberbegriff des Patentanspruchs 1.

Ein Verfahren der eingangs genannten Art ist aus der DE-C-34 32 848 bekannt. Dort ist vorgeschlagen worden, von allen Sendern einer Sendergruppe eine Folge von Listen alternativer Frequenzen auszustrahlen, wobei jede dieser Listen an ihrem Anfang die Betriebsfrequenz des der betreffenden Liste zugeordneten Senders erhält, um aus der Folge von Listen die jeweils passende und auf den empfangenen Sender optimierte Liste selektieren zu können.

Ein sicherer Empfang einer solchen Folge von Listen setzt jedoch voraus, daß der nachstehend als "Header" bezeichnete Anfang jeder Liste mit der Betriebsfrequenz des der jeweiligen Liste zugeordneten Senders korrekt empfangen wird. Ist dies nicht der Fall - beispielsweise infolge von Störungen durch Mehrwegeempfang -, so können die auf den Header jeder Liste folgenden alternativen Frequenzen empfangsseitig nicht verwertet werden, und zwar auch dann nicht, wenn sie korrekt empfangen werden, denn es kann keine korrekte Zuordnung zu der betreffenden Betriebsfrequenz erfolgen.

Es wurde daher auch schon vorgeschlagen (Firma Blaupunkt-Werke GmbH, Hildesheim), sämtliche alternativen Frequenzen einer Senderkette - die aus mehreren Sendergruppen (z.B. BR-Nord und BR-Süd) bestehen kann - in Form einer Matrix zu übertragen, wobei zu jedem Sender die zugehörigen alternativen Frequenzen als Matrixnachbarn innerhalb der Matrix gruppiert sind. Dieses sog. "Matrixverfahren" hat jedoch den Nachteil, daß infolge der Gruppierungsvorschrift Nachbarn unvermeidlich sein können, welche in Wirklichkeit gar keine im obigen Sinne alternativen Frequenzen sind, so daß empfangsseitig entsprechende Falschabstimmungen auf solche Nachbarn auftreten können. Darüberhinaus ist das Erstellen und das Ändern einer Matrix außerordentlich kompliziert, wobei unter Umständen eine Neubelegung einer freigewordenen Sendefrequenz nur deshalb nicht möglich sein könnte, weil eine bestehende Matrix eine solche Änderung nicht zuließe.

Bei dem - in dem nachfolgend als "EBU-Dokument" bezeichneten Technischen Dokument Doc.Techn. Nr. 3244 der Europäischen Rundfunk-Union spezifizierten - Radio-Daten-System (RDS) ist das Übertragen zusätzlicher Informationen, z.B. das Übertragen alternativer Frequenzen (AF-Code), insbesondere in Form von in einer Liste zusammengefaßten alternativen Frequenzen, als Inhalt eines auf einen 57 kHz-Hilfsträger aufmodulierten Datenstroms vorgesehen. Diese Information ist sowohl beim mobilen Empfang (z.B. bei Autoradios) - etwa beim Verlassen des Ausstrahlungsbereichs eines Senders - als auch beim stationären Empfang - etwa bei Ausfall oder Störung eines Senders - von Interesse. Bei geeignet ausgebildeten Empfängern mit Speicher lassen sich solche Listen abzuspeichern und so die Zeit zum Einstellen des Empfängers auf die jeweils optimale Frequenz dieser Liste (z.B. nach optimalen Empfangsbedingungen) reduzieren.

Das RDS-Datensignal umfaßt daneben unter anderem eine sogenannte Programme-Identifikation-Information (PI-Code), wobei mit Hilfe des AF-Code unmittelbar und mit Hilfe des PI-Code mittelbar diejenigen alternativen Sendefrequenzen feststellbar sind, auf welchen das Programmsignal der momentanen Empfangsfrequenz ebenfalls empfangbar ist.

Die empfangsseitige Auswertung der alternativen Sendefrequenzen kann in der Weise erfolgen, daß der Empfänger kurzzeitig nacheinander auf die alternativen Frequenzen für jede alternative Frequenz festgestellt wird. Anschließend werden die Empfangsfeldstärken der alternativen Frequenzen und der momentanen Empfangsfrequenz miteinander verglichen, wobei diejenige Frequenz selektiert und als neue Empfangsfrequenz eingestellt wird, welche die höchste gemessene Empfangsfeldstärke liefert (dies kann natürlich auch die bisher eingestellte Empfangsfrequenz sein).

Dabei zeigt sich jedoch das Problem, daß es Fälle gibt, bei denen die Messung der Empfangsfeldstärke - insbesondere bei Mehrwegeempfang - keine zuverlässige Qualitätsaussage über den Empfang bietet. Bei Mehrwegeempfang sind die durch Signaleinbrüche verursachten Empfangsstörungen von den Umwegen, von der momentanen Signalaussteuerung (die von der Programmart - beispielsweise klassische Musik oder Pop-Musik - bestimmt wird) und beim mobilen Empfang von der Fahrzeuggeschwindigkeit abhängig. Ein Empfangssignal, welches durch Mehrwegeempfang gestört ist, kann trotz einer relativ hohen Empfangsfeldstärke zwischen den Signaleinbrüchen subjektiv als außerordentlich störend empfunden werden, wohingegen ein Empfangssignal, welches lediglich durch Rauschen gestört ist, als wesentlich besser empfunden werden kann.

Im Ergebnis kann die geschilderte Auswahl des bestmöglichen Empfangs eines gewählten Programmsignals dazu führen, daß der Empfang dauernd durch Mehrwegeempfangsstörungen beeinträchtigt ist. Dieses unerwünschte Ergebnis läßt sich dadurch nicht wesentlich ändern, daß - etwa mit Hilfe eines zweiten Tuners im Empfänger - auf die alternativen Frequenzen über einen längeren Meßzeitraum abgestimmt wird und die gemessenen Empfangsfeldstärken integriert werden, da auch bei einer solchen Integration in der Regel die durch Mehrwegeempfang gestörten Empfangssignale eine höhere durchschnittliche Empfangsfeldstärke aufweisen als diejenigen Empfangssignale, welche nur durch Rauschen gestört sind.

Solche Störungen können jedoch nicht nur das Programmsignal beeinträchtigen. Auch die zusätzlichen, beispielsweise im RDS-Datenstrom übertragenen Informationen können in Mitleidenschaft gezogen sein, so daß es empfangsseitig unter Umständen entweder zu langen Wartezeiten bis zum Vorliegen wieder korrekt empfangener RDS-Informationen oder aber zu Fehlinterpretationen kommen kann. Dies fällt im allgemeinen besonders negativ ins Gewicht bei Daten, deren Wiederholzyklus im Datenstrom relativ lang ist.

Ein weiteres Problem bezüglich der Programmsignalqualität hat seine Ursachen in der Sendernetzstruktur in einigen Ländern, insbesondere in solchen Ländern mit einander überlappenden Sendernetzen. Da die von einem Muttersender zentral ausgesendeten digitalen Informationen, etwa eine Liste über Alternative Frequenzen, für den per Ballempfang vom Muttersender gespeisten Tochtersender (z.B. Umsetzer) unter Umständen nicht paßt, müßte sie nach dem Ballempfänger ausgefiltert und durch die für den jeweiligen Tochtersender zutreffende Liste ersetzt werden. Diese Ausfilterung und Neueinspeisung ist mit erhöhtem Auswand verbunden. Hinzu kommt, daß durch die Filterung auch die Qualität des Programmsignals verschlechtert wird.

Der Erfindung liegt demgegenüber die Aufgabe zugrunde, bei den Verfahren der eingangs genannten Art die Empfangsqualität zu verbessern.

Diese Aufgabe wird erfindungsgemäß durch die in Patentanspruch 1 aufgeführten Merkmale gelöst.

Die Erfindung beruht auf der Erkenntnis, daß die Empfangsqualität zum einen dadurch verbessert werden kann, daß die alternativen Frequenzen so übertragen werden, daß sie empfangsseitig sicherer zu den jeweiligen Senderbetriebsfrequenzen zugeordnet werden können. Dies hat den Vorteil, daß der Empfänger dann im Bedarfsfall schneller auf eine einen besseren Empfang bietende alternative Frequenz abgestimmt werden kann. Dies gilt sogar selbst dann, wenn der Empfänger eine nur geringe Speicherkapazität aufweisen sollte.

Einer Weiterbildung der Erfindung entsprechend kann die Empfangsqualität dadurch verbessert werden, daß für die Beurteilung der Empfangsqualität nicht oder jedenfalls nicht ausschließlich die Empfangsfeldstärke, sondern akustische und/oder Programmsignalverzerrungen verwendet werden. Dies hat den Vorteil, daß solche alternativen Frequenzen, die nur "scheinbar" - nämlich wegen einer höheren Empfangsfeldstärke - einen besseren Empfang bieten, in Wirklichkeit aber vom Benutzer als schlechter empfunden werden, empfangsseitig verworfen werden können.

Liegen die innerhalb des Rundfunksignals übertragenen zusätzlichen Daten wie beim RDS-Datensignal in Form von digitalen Informationen vor, so können als Maß für die Programmsignalverzerrungen die Bitfehler im RDS-Datensignal herangezogen werden. Es hat sich nämlich gezeigt, daß die Bitfehler in dem RDS-Datensignal relativ genau mit den Programmsignalverzerrungen korrelieren, obwohl das Programmsignal im Basisband von 0 bis 53 kHz und das RDS-Datensignal auf einem 57 kHz-Träger mit einem Hub von minimal - 1,2 kHz übertragen werden.

Aufgrund dieser Korrelation läßt sich in Weiterbildung der Erfindung der Umstand ausnutzen, daß Störungen durch Mehrwegeempfang oder Interferenz burstartig auftretende Bitfehler des RDS-Datensignals hervorrufen, wohingegen Störungen durch Rauschen gleichförmig verteilte Bitfehler zur Folge haben. Der Grad aller Störungen läßt sich dabei aus der Blockfehlerrate ableiten, welche völlig unabhängig vom Dateninhalt ermittelt werden kann.

Ausgehend hiervon wird für eine optimale Auswahl der den besten momentanen Empfang ermöglichenden Frequenz ein Tuner des Empfängers nacheinander auf die alternativen Frequenzen sowie auf die eingestellte Empfangsfrequenz in zeitlichen Intervallen abgestimmt. Bei einer etwas komfortableren Empfängerkonzeption ist für eine optimale Auswahl der den besten momentanen Empfang ermöglichenden Frequenz ein zweiter Tuner des Empfängers vorgesehen, der nacheinander auf die alternativen Frequenzen sowie auf die eingestellte Empfangsfrequenz des ersten Tuners in Intervallen von beispielsweise mindestens 2 Sekunden abgestimmt wird.

Während dieser - bei der Empfängerkonzeption mit zwei Tunern relativ langen - Abstimmintervalle werden für das gesamte empfangene RDS-Datensignal (welches außer den alternativen Frequenzen eine Fülle weiterer Informationen enthält) die Bitfehler festgestellt. Anschließend werden die für jede alternative Frequenz und für die momentane Empfangsfrequenz festgestellten Bitfehlerverteilungen und Blockfehlerraten wie folgt ausgewertet:

Falls alle überprüften Frequenzen nur burstartig oder nur gleichförmig verteilte Bitfehler aufweisen, was gleichbedeutend damit ist, daß bei allen Frequenzen Empfangssignalstörungen durch Mehrwegeempfang, Interferenz oder Rauschen vorliegen, werden die zugehörigen Blockfehlerraten miteinander verglichen, wobei diejenige Frequenz mit der geringsten Blockfehlerrate als optimale Empfangsfrequenz ausgewählt wird. Der Tuner des Empfängers - bzw. im Fall des zwei Tuner aufweisenden Empfängers der erste Tuner - wird dann auf diese ausgewählte Frequenz abgestimmt, sofern nicht die bereits eingestellte Empfangsfrequenz mit der ausgewählten Frequenz identisch ist.

Für den Fall, daß die überprüften Frequenzen unterschiedliche Störungen, also sowohl durch Rauschen als auch durch Mehrwegeempfang verursachte Bitfehler aufweisen, werden zunächst diejenigen Frequenzen vorselektiert, welche im wesentlichen durch Rauschen und nicht durch Mehrwegeempfang gestört sind, d.h., welche im wesentlichen gleichförmig verteilte Fehler aufweisen. Um stark verrauschte Signale auszuschließen, können nur solche Frequenzen vorselektiert werden, bei deren RDS-Datensignal eine maximal zulässige Blockfehlerrate nicht überschritten wird. Anschließend werden die vorselektierten Frequenzen hinsichtlich ihrer festgestellten Blockfehlerrate miteinander verglichen, wobei wiederum diejenige Frequenz mit der geringsten Blockfehlerrate als optimale Empfangsfrequenz ausgewählt wird.

Die vorstehende Auswahl der optimalen Frequenz kann bei ausreichend langem Meßintervall je alternativer Sendefrequenz ohne Berücksichtigung der jeweiligen Empfangsfeldstärke erfolgen. Insbesondere bei geringeren Meßintervallen kann zusätzlich die Empfangsfeldstärke für die Auswahl herangezogen werden, wobei die Gewichtung zwischen Empfangsfeldstärke einerseits und Signalverzerrungen andererseits empirisch festgelegt werden kann.

Die alternativen Frequenzen können mit Hilfe des PI-Codes oder des AF-Codes oder unter Verwendung und gegebenenfalls Ergänzung - im Falle von Mehrdeutigkeiten oder unvollständiger Übertragung - beider Codes festgestellt werden. Der PI-Code identifiziert Frequenzen, auf welchen dasselbe Programmsignal empfangbar ist. Durch Vergleich des PI-Codes beim Sendersuchlauf kann eine eindeutige Zuordnung von momentaner Empfangsfrequenz und dessen alternative Frequenzen erfolgen. Diese Zuordnung kann aus dem AF-Code unmittelbar entnommen werden. Falls der AF-Code nicht im RDS-Datensignal übertragen wird oder falls der AF-Code fehlerbehaftet ist, können daher die alternativen Frequenzen auch aus dem PI-Code abgeleitet bzw. ergänzt werden.

Mit Hilfe des erfindungsgemäßen Verfahrens ist es möglich, die mit der Einführung des RDS-Systems und der darin enthaltenen alternativen Frequenzen angestrebten Vorteile eines stets optimalen Empfangs von Rundfunkempfängern (sowohl von mobilen als auch von ortsfesten Rundfunkempfängern) erstmals durch ein völlig neuartiges Konzept zur Ermittlung der optimalen Empfangsqualität zu verwirklichen. Dabei lassen sich mit Hilfe des RDS-Datensignals die Probleme des Mehrwegempfangs des Nutzsignals in überraschender Weise wesentlich verringern.

Bei dem erfindungsgemäßen Verfahren ist vorgesehen, bei der Folge von einzelnen Listen, die in den digitalen Informationen des RDS-Datenstroms enthalten sind und die ihrerseits den jeweiligen Sendern einer Senderkette zugeordnete oder auf diese jeweiligen Sender optimierte alternative Frequenzen enthalten, die in oder zu jeder Liste vorgesehene Betriebsfrequenz des zugehörigen Senders nicht nur am Anfang der Liste zu übertragen, sondern zusätzlich vor jeder einzelnen alternativen Frequenz der betreffenden Liste, so daß jede alternative Frequenz mit der Betriebsfrequenz "adressiert" ist. Jede Liste besteht somit aus einer Folge digitaler Informationsblöcke, wobei jeder Block aus zwei Informationen besteht. Eine dieser Informationen jedes Blockes ist (bis auf ganz spezielle Ausnahmen) die Betriebsfrequenz des der jeweiligen Liste zugeordneten Senders. Falls daher ein Teil der Liste inkorrekt übertragen oder empfangen wird, können die korrekt empfangenen alternativen Frequenzen infolge ihrer Paarung mit der Betriebsfrequenz eindeutig dem zugehörigen Sender zugeordnet werden und in dessen Liste empfangsseitig einsortiert werden. Da es unwahrscheinlich ist, daß in einer betrachteten Liste stets derselbe Informationsblock gestört ist, kann aus zwei oder drei aufeinanderfolgend empfangenen gestörten Listen desselben Senders die vollständige Liste empfangsseitig gespeichert werden.

Die vorstehend erläuterte Paarung jeder alternativen Frequenz mit der Betriebsfrequenz des der Liste zugeordneten Senders erhöht im Vergleich zu dem Verfahren gemäß der DE-C-34 32 848 die Anzahl der je Liste zu übertragenden Frequenzinformationen auf das Doppelte, wodurch die Zyklusdauer für jede Folge von Listen entsprechend vergrößert wird. Man könnte daher annehmen, daß die Empfangswahrscheinlichkeit und -sicherheit bei einer solchen verlängerten Zyklusdauer eher verschlechtert als verbessert wird. In der Tat wird für das eingangs erwähnte Matrixverfahren als Vorteil gegenüber dem Listenverfahren nach der DE-C-34 32 848 die geringere Zyklusdauer einer Matrix gegenüber einer Folge einzelner Listen geltend gemacht und hieraus eine höhere Empfangssicherheit abgeleitet.

Es muß daher für die Fachwelt überraschen, daß trotz der erheblichen Vergrößerung der Zyklusdauer der erfindungsgemäß übertragenen Folge von Listen die Empfangssicherheit entscheidend höher ist als beim Matrixverfahren und beim gattungsgemäßen Listenverfahren. Der nicht vorhersehbare Grund für diesen überraschenden Vorteil liegt darin, daß infolge der geschilderten Adressierung jeder alternativen Frequenz mit der Betriebsfrequenz auch bei äußert schlechten Empfangsverhältnissen noch eine sichere Zuordnung der korrekt empfangenen alternativen Frequenzen möglich ist, was bei den beiden anderen Verfahren nicht der Fall ist, so daß deren kürzere Zyklusdauer in solchen Empfangssituationen nichts nützt.

Weitere Merkmale, Vorteile und Einzelheiten der Erfindung werden nachstehend an drei Ausführungsbeispielen anhand der Zeichnungen näher erläutert. Dabei zeigen:
- Fig. 1: eine schematische Darstellung der von jedem Sender einer Senderkette abgestrahlten Folge von Listen alternativer Frequenzen gemäß einem ersten Ausführungsbeispiel der Erfindung,
- Fig. 2: zeigt ein Blockschaltbild eines Empfängers für ein Verfahren gemäß einem zweiten Ausführungsbeispiel der Erfindung
- Fig. 3: zeigt ein Blockschaltbild eines Empfängers für ein Verfahren gemäß einem dritten Ausführungsbeispiel der Erfindung

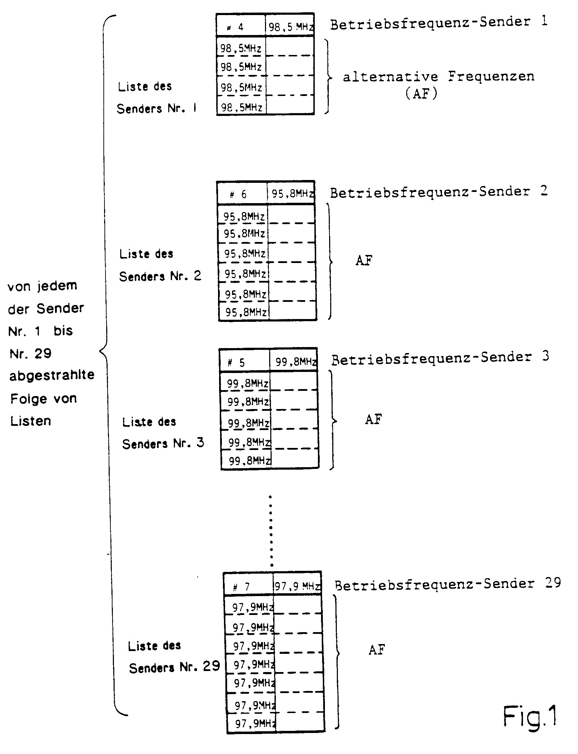

In Fig. 1 ist schematisch ein System von alternativen Listen dargestellt, das als zusätzliche Information eines Rundfunksenders übertragen wird. Im betrachteten Beispielsfall wird von einem Rundfunksignal ausgegangen, in welches ein Hilfsträger von 57 kHz eingefügt ist. Der Hilfsträger kann eine Amplitudenmodulation enthalten, welche eine Verkehrsfunkkennung zum Inhalt hat. Als Modulation bzw. als weitere Modulation ist dem Hilfsträger ein Datensignal aufgeprägt, welches in einer bestimmten, hier nicht näher interessierenden Weise codiert ist. Dieses Datensignal wird in übereinstimmender Form von sämtlichen Sendern einer Senderkette mit demselben Programm übertragen, beispielsweise von sämtlichen Sendern der Senderkette "Bayern 3" im Versorgungsbereich des Bayerischen Rundfunks (abgekürzt: BR). Das übereinstimmend übertragene Datensignal enthält unter anderem eine Folge von Listen alternativer Frequenzen für sämtliche Sender der Senderkette, im dargestellten Beispielsfall die Liste des Senders Nr. 1, die Liste des Senders Nr. 2, die Liste des Senders Nr. 3, bis zur Liste des Senders Nr. 29 für den Fall einer Senderkette mit 29 Sendern. Jede Liste ist auf den jeweiligen Sender speziell zugeschnitten und enthält die für diesen Sender vorgesehenen alternativen Frequenzen, also die Frequenzen derjenigen Sender, welche im Empfangsgebiet des betreffenden Senders alternativ auf demselben Programm empfangbar sind. Beispielsweise kann im Raum München das Programm "Bayern 3" alternativ von dem Sender "Wendelstein" oder dem Sender "Ismaning" empfangen werden. Ist der Empfänger auf den Sender Wendelstein abgestimmt, so kann bei einer Empfangsverschlechterung, z.B. infolge Mehrwegeempfangs, der Empfänger aufgrund seiner Kenntnis über die "Alternative" Ismaning kurzzeitig auf den Empfänger Ismaning abstimmen und dessen Empfangsfeldstärke überprüfen; ist letztere besser, wird auf den Sender Ismaning umgeschaltet, wobei dieser Prüfvorgang für den Zuhörer praktisch nicht hörbar ist.

Jede Liste besteht aus einer Folge von digitalen Informationsblöcken, welche in Fig. 1 als horizontale Zeilen innerhalb der Liste angedeutet sind. Jeder Informationsblock besteht aus einem Paar von Informationen, wie durch die vertikale Trennung der Liste in eine linke und eine rechte Hälfte angedeutet ist. Der erste, als "Header" bezeichnete Block jeder Liste enthält in der linken Blockhälfte die Anzahl der alternativen Frequenzen innerhalb der betreffenden Liste. Im Falle der Liste des Senders Nr. 1 mit vier alternativen Frequenzen enthält der Header die Zahl # 4, im Falle der Liste des Senders Nr. 29 mit sieben alternativen Frequenzen enthält der Header die Zahl #7. In der rechten Blockhälfte enthält der Header jeder Liste die Betriebsfrequenz des der Liste zugeordneten Senders. Im Falle der Liste des Senders Nr. 1 mit der Betriebsfrequenz 98,5 MHz ist in der rechten Hälfte des Headers die Frequenzinformation 98,5 MHz enthalten. Im Falle der Liste des Senders Nr. 29 mit der Betriebsfrequenz 97,9 MHz wird im Header die Frequenzinformation "97,9 MHz" übertragen.

Was das Vorsehen der Betriebsfrequenz eines Senders am Anfang einer ihn betreffenden Liste von alternativen Frequenzen angeht, so besteht Übereinstimmung mit dem Verfahren gemäß der DE-C-34 32 848. Sofern außerdem eine in dem EBU-Dokument für das Übertragungsformat von alternativen Frequenzen vorgesehene Blockbelegung (Gruppe vom Typ OA) Anwendung fände, würden dort in den auf den Header folgenden Blöcken jeder Liste zwei alternative Frequenzen übertragen, so daß im Falle der Liste Nr. 1 mit vier alternativen Frequenzen auf den Header zwei Blöcke mit 2*2 = 4 alternativen Frequenzen folgten.

Demgegenüber wird im vorliegenden Ausführungsbeispiel gemäß der Erfindung in jedem auf den Header folgenden Block die der Liste zugeordnete Betriebsfrequenz übertragen, und zwar zusammen mit einer alternativen Frequenz. Diese Paare enthalten somit die Betriebsfrequenz als Adresse für die jeweilige alternative Frequenz, was den schon erwähnten Vorteil hat, daß die Empfangssicherheit drastisch erhöht wird, obwohl die Anzahl der je Liste erforderlichen Blöcke, die auf den Header folgen, verdoppelt wird.

Im Fall der Liste des Senders Nr. 1 müssen nach dem Header - statt zweier Blöcke wie gemäß der vorstehend erwähnten Kombination aus EBU-Dokument und DE-C-34 32 848 - nunmehr vier Blöcke übertragen werden, was eine entsprechende Erhöhung der Übertragungszeit für die Folge von 29 betrachteten Listen mit sich bringt. Da diese Übertragungszeit gleich der Zyklusdauer jeder Folge von Listen ist, könnte man glauben, daß infolge dieser Verlängerung der Zyklusdauer die Empfangssicherheit bei Übertragungsstörungen verschlechtert wird. Diese Vermutung ist jedoch, wie schon dargelegt, falsch, so daß der überraschende Effekt zu verzeichnen ist, daß bei dem erfindungsgemäßen Verfahren gemäß diesem Ausführungsbeispiel trotz Verlängerung der Zyklusdauer die Empfangssicherheit deutlich gegenüber dem Listenverfahren und dem Matrixverfahren vergrößert ist.

Im Falle von Sendern, deren Betriebsfrequenz nicht im 100 kHz-Raster liegt, sondern dazwischen (sog. Offset-Frequenzen), z.B. 92,85 MHz beträgt, wird im Header der betreffenden Liste nicht die Betriebsfrequenz, sondern eine Sonderinformation, ein sog. "Fillercode" gemäß dem eingangs erwähnten Dokument der Europäischen Rundfunk-Union übertragen. In dem darauf folgenden Block wird zuerst die Offset-Frequenz, z.B. "92,85 MHz" und dann die "Quasi-Betriebsfrequenz", z.B. "92,8 MHz" übertragen. Diese Quasi-Betriebsfrequenz wird in den folgenden Blöcken an erster Stelle als Adresse für die alternativen Frequenzen übertragen.

Eine weitere Abweichung von der in der Zeichnung dargestellten Übertragungsregel für die einzelnen Listen ergibt sich, falls eine der alternativen Frequenzen eine Offset-Frequenz ist. In diesem Falle wird im entsprechenden Block anstelle der Betriebsfrequenz die Offset-Frequenz der alternativen Frequenz übertragen, umd zwar zusammen mit der "Quasi-alternativen Frequenz", die im 100 kHz-Raster liegt.

Zur Identifizierung von alternativen Frequenzen solcher Sender, welche im Rahmen von Regionalprogrammen für einige Zeit eines Sendetages oder einer Sendewoche aus der zugeordneten Senderkette herausgeschaltet werden, z.B. Sender, die von 6.00 bis 12.00 Uhr das Programm "Bayern 3", von 12.00 bis 13.30 Uhr das Regionalprogramm "Neues aus Schwaben" und von 13.30 bis 24.00 Uhr wieder das Programm "Bayern 3" übertragen, kann es günstig sein, im zugeordneten Block die Reihenfolge von Betriebsfrequenz und alternativer Frequenz zu vertauschen, also zuerst die alternative Frequenz und dann die Adresse "Betriebsfrequenz" im Block zu übertragen.

Jede Liste ist auf den jeweiligen Sender speziell zugeschnitten und enthält entsprechend der Vereinbarung innerhalb der Europäischen Rundfunk-Union maximal 25 Frequenzen, im Regelfall jedoch erheblich weniger. Am Beginn jeder Liste steht die Betriebsfrequenz des zugehörigen Senders, d.h. bei der Liste des Senders Nr. 1 steht am Anfang die Betriebsfrequenz des Senders Nr. 1, z.B. 98,5 MHz. Wie erwähnt, wird die dargestellte Folge von 29 Listen von jedem Sender der Senderkette als Datensignal übertragen.

Der Empfänger empfängt und decodiert das übertragene Datensignal, d.h. die Folge von Listen alternativer Frequenzen. Um die für den momentan abgestimmten Sender gültige Liste aus der empfangenen Listenfolge zu selektieren, braucht der Empfänger lediglich die erste Frequenz jeder Liste mit der momentanen Abstimmfrequenz zu vergleichen, was selbst bei 29 Listen in äußerst kurzer Zeit durchführbar ist. Diese Selektion kann entweder im On-Line-Betrieb oder im Off-Line-Betrieb erfolgen, d.h., ohne oder mit Zwischenspeicherung der empfangenen Folge von Listen. In einem bevorzugten Ausführungsbeispiel wird die selektierte Liste in jedem Falle gespeichert.

Bei der Verarbeitung der empfangenen und ggf. zwischengespeicherten Folge von Listen selektiert der Empfänger diejenige Liste, deren erste Frequenz (gleich Betriebsfrequenz des zugeordneten Senders) mit der momentanen Abstimmfrequenz übereinstimmt. Stimmt die erste Frequenz mehrerer Listen mit der eingestellten Betriebsfrequenz überein, so müssen alle diese Listen selektiert werden. Ausschließlich die selektierte(n) Liste(n) wird (werden) für die anschließende Optimierung der Abstimmung verwendet.

Dieser Abstimmvorgang erfolgt entweder durch einen entsprechenden Befehl des Zuhörers oder automatisch, wenn beispielsweise der momentan empfangene Sender nicht mehr empfangswürdig ist. Bei dem Abstimmvorgang stimmt der Empfänger selbsttätig auf die in der (den) selektierten Liste(n) aufgeführten alternativen Frequenzen ab und selektiert diejenige alternative Frequenz, welche den bestmöglichen Empfang bietet. Mit Hilfe des übertragenen Datensignals RDS läßt sich auch bei Senderketten mit mehr als der festgelegten maximalen Anzahl von alternativen Frequenzen eine rasche Optimierung der Abstimmung mobiler Empfänger durchführen, ohne daß eine Ausfilterung und Neueinspeisung von Frequenzlisten am Standort von Tochtersendern erforderlich wird.

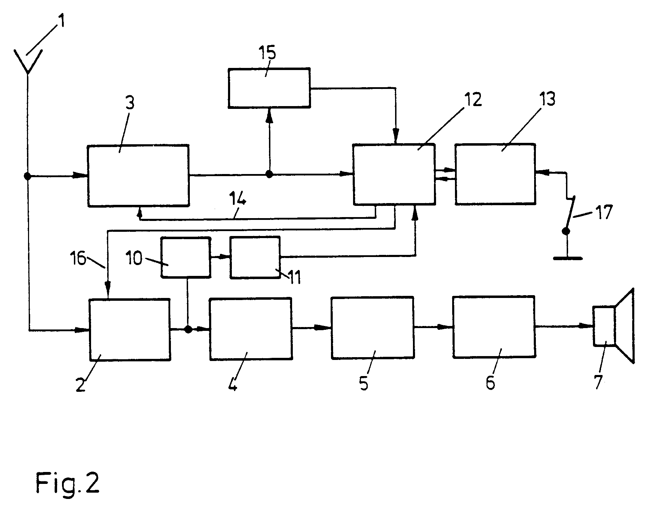

Fig. 2 zeigt zeigt ein Blockschaltbild eines Empfängers für ein Verfahren gemäß einem zweiten Ausführungsbeispiel der Erfindung. Dabei wird auf das anhand von Fig. 1 beschriebene System Bezug genommen.

Die mit einer Antenne 1 empfangenen, zusätzliche Daten enthaltenden Rundfunksignale werden einerseits einem Tuner 2 und andererseits einem Tuner 3 zugeführt. Der Tuner 2 ist Teil eines Rundfunkempfangsgeräts mit einem Zwischenfrequenzverstärker 4 für die vom Tuner gelieferte Zwischenfrequenz sowie mit einem Demodulator 5 für die Rückgewinnung der Niederfrequenzsignale und mit einem Verstärker 6 für die Niederfrequenzsignale, sowie mit einem Lautsprecher 7 für die akustische Wiedergabe. An den Signalweg, z.B. an den Ausgang des Tuners 2, ist eine Schaltung 10 zur Selektion des 57 kHz-Trägers angeschlossen, der mit einer Schaltung 11 zur Rückgewinnung der Daten verbunden ist. Die Daten werden einem Speicher 12 zugeführt. In diesen Speicher 12 werden ständig die alternativen Frequenzen (AF) des vom Tuner 2 empfangenen Betriebsfrequenzsenders eingelesen.

Der Tuner 3 dient zur ständigen Abtastung der vom Tuner 2 empfangbaren Frequenzbereiche. Seine hoch- oder zwischenfrequenten Ausgangssignale werden ebenfalls dem Speicher 12 zugeführt. Die vom Tuner 3 abgetasteten Frequenzen werden Ständig mit den entsprechend gespeicherten Frequenzen verglichen, um ein Maß für den momentan am besten zu empfangenden Sender zu schaffen. Die vom Tuner 3 jeweils einzustellende Frequenz wird vom Speicher 12 mittels eines Mikroprozessors 13 über eine Leitung 14 bestimmt und der Tuner 3 entsprechend abgestimmt.

Eine Schaltung 15 dient zur Messung der Feldstärke des jeweils empfangenen Senders. Sobald die Feldstärkemessung ergibt, daß die Signale eines anderen Senders eine größere Feldstärke haben als der vom Tuner 2 eingestellte Betriebsfrequenzsender, wird der Tuner 2 über eine Leitung 16 auf den Sender momentan größerer Feldstärke umgestellt.

Bei der soweit beschriebenen Schaltung ist es möglich, daß aufgrund von Interferenzen, z.B. solchen, die durch Reflexionen verursacht werden, Verzerrungen des akustisch wiedergegebenen Audiosignals auftreten. Solche Interferenzen treten meist in der Nähe sehr starker Sender auf. Auch kann durch eine große Feldstärke am momentanen Empfangsort eine Übersteuerung des Empfängers eintreten, durch die die akustische Wiedergabe verzerrt wird.

Bei bekannten Verfahren, beispielsweise nach der DE-C 34 48 043, wird nach Auswahl eines Senders eine vollautomatische Abstimmung ohne Mitwirkung des Benutzers auf denjenigen Sender mit demselben Programm ermöglicht, welcher am momentanen Empfängerstandort am bestem empfangbar ist,d.h. die größte Feldstärke liefert.

Zu diesem Zweck wird jeder Sender nicht nur seine eigene Liste, sondern sequentiell auch die Listen aller weiteren Sender derselben Senderkette ausstrahlen, wobei die Betriebsfrequenzen der einzelnen Sender jeweils am Anfang der einzelnen Listen stehen. Der Empfänger kann so nach erfolgtem Empfang aller Listen aufgrund seiner momentanen Abstimmfrequenz die zu dem momentan eingestellten Sender gehörende Liste selektieren, indem er die Abstimmfrequenz mit der ersten Frequenz jeder Liste innerhalb der Listenfolge vergleicht. Ferner erkennt der Empfänger auch die alternativen Frequenzen, auf denen er bei Verlassen des Versorgungsbereichs des momentan eingestellten Senders das gleiche Programm weiter empfangen kann, ohne daß er die alternativen Frequenzen der übrigen Listen prüfen muß. Das Umschalten auf einen anderen Sender derselben Senderkette kann auf diese Weise in der Regel sehr rasch durchgeführt werden.

Doch gerade beim Empfang von Sendern mit großer anstehender Feldstärke kann die akustische Wiedergabe verzerrt sein kann. Das kann beispielsweise auf einer Übersteuerung infolge zu starker Empfangsfeldstärke beruhen oder auf Interferenzerscheinungen durch Reflexionen.

Bei dem vorliegenden Ausführungsbeispiel gemäß der Erfindung ist daher vorgesehen, eine Sendereinstellung unter Beibehaltung der automatischen Umschaltung auf andere dasselbe Programm ausstrahlende Sender zu ermöglichen, bei der akustische Verzerrungen bei der Wiedergabe weitgehend vermieden oder verringert werden.

Durch einen Schalter 17 wird in dem Mikroprozessor 13 ein Schaltzustand erzeugt, bei dem nicht der stärkste Sender, sondern ein schwächerer Sender, insbesondere der zweitstärkste Sender für den Vergleich mit dem jeweils eingestellten Betriebsfrequenzsender herangezogen wird.

Durch zusätzliche Ausbildung des Schalters 17 als Rückstelltaste wird erreicht, daß die Einstellung des Gerätes auf Sender kleinerer als der momentanen größten Feldstärke widerrufen werden kann, wenn die Nahzone oder Störzone des Senders verlassen wird. Ein mehrmaliger Schaltvorgang wird so erleichtert möglich. Die Wirkung des Schalters 17 auf den Mikroprozessor 13 kann auch so ausgelegt sein, daß durch mehrmaliges kurzes Antippen von Schalter 17 alle Sender entsprechend der gespeicherten alternativen Liste nacheinander mit fallender Feldstärke einstellbar sind. Durch ein längeres Betätigen von Schalter 17 z.B. über mehrere Sekunden kann der Rücksetzvorgang ausgelöst werden.

Der Tuner 3 kann im Fig. 2 eine andere Ausführung haben als der Tuner 2, da seine eigentliche Aufgabe nur das Abtasten des Frequenzbandes zur Kontrolle evtl. stärkerer Sender ist. Eine Signalqualität muß also nicht erreicht werden.

Es ist auch möglich, bei Verwendung von nur einem Tuner eine Feldstärkenumschaltung in der beschriebenen Form durchzuführen, wobei allerdings für den Benutzer während des Abfragevorganges Sender mit geringeren Feldstärken empfangen werden können.

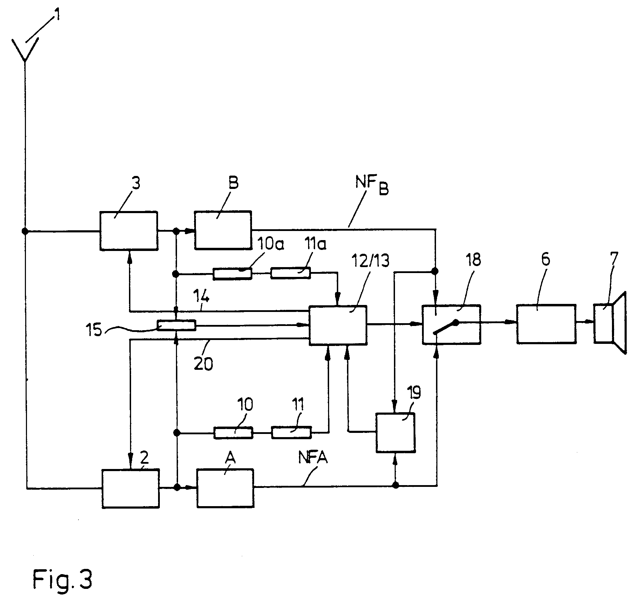

Fig. 3 zeigt in einem dritten Ausführungsbeispiel der Erfindung eine Abwandlung der in Fig. 2 dargestellten Schaltung, bei der zwei gleichwertige Tuner 2 und 3 in zwei getrennte Empfängerzüge A, B eingeschaltet sind, die jeder ein NF-Ausgangssignal NF_{A}, NF_{B} zu einem NF-Schalter 18 liefern, der jeweils eines der beiden Signale zum NF-Verstärker 6 und Lautsprecher 7 weiterleitet. Aus dem Tuner 2 werden die Datensignale (z.B. aus dem RDS-Datenstrom) mittels der Auswahlschaltung 10, 11 selektiert und dem Speicher 12 mit Mikroprozessor 13 zugeführt. Aus dem Tuner 3 werden ebenfalls die Datensignale selektiert und dem Speicher 12 mit Mikroprozessor 13 zugeführt. Tuner 2 ist durch manuelle bzw. willkürliche Eingabe abstimmbar. Tuner 3 wird durch den Speicher 12 bzw. den Mikroprozessor 13 über Leitung 14 entsprechend der gespeicherten alternativen Liste abgefragt.

Die Erkennung des jeweiligen Senders mit der größten Feldstärke erfolgt in Schaltung 15 durch Vergleich der empfangenen Signale vom Tuner 2 und Tuner 3. Für den Fall, daß mit dem Tuner 2 nicht der Sender mit der optimal zu empfangenden Feldstärke eingestellt ist, übernimmt der Tuner 3 diesen feldstärksten Sender, und dessen NF-Ausgangssignal NF_{B} wird über den Schalter 18 an dem NF-Verstärker 6 und Lautsprecher 7 gelegt.

In diesem Schaltzustand wird Tuner 2 über Leitung 20 vom Mikroprozessor 12/13 entsprechend der in den alternativen Listen gespeicherten Frequenzen abgefragt.

Die NF-Signale NF_{A} und NF_{B} werden einer Schaltung 19 zum Vergleich der Modulation beider Signale zugeführt. In dieser Modulationsvergleichsschaltung wird der Modulationsinhalt des mit der größten Feldstärke eingestellten Senders mit dem Modulationsinhalt der aus der alternativen Liste ausgewählten Sender verglichen. Zweckmäßigerweise erfolgt dieser Vergleich jeweils mit dem zweitstärksten Sender aus der Liste.

Der Vergleich kann durch direkten Vergleich des zeitlichen Verlaufes der Niederfrequenzspannung oder durch Vergleich der Hüllkurven der beiden NF-Signale geschehen. Zeigt dabei der Sender mit der größeren Feldstärke durch Reflektionseinwirkung Modulationseinbrüche oder Modulationsvertiefungen und Abkappungen der NF durch Übersteuerung, wird automatisch Schalter 18 durch den Mikroprozessor 12/13 auf den zweitstärksten Sender umgeschaltet, so daß die Verzerrungen für den Nutzer nicht erkennbar sind. Sind beide Signale identisch, bleibt der Sender mit der jeweils größeren Feldstärke angeschaltet. In der Folge kann der Schalter 18 ständig von dem gerade wirksamen Empfänger A, B auf den jeweils anderen Empfänger B, A umgeschaltet werden in Abhängigkeit von der Steuerung des Mikroprozessors. Lediglich bei manueller oder anderer Eingabe durch den Nutzer wird Tuner 2 wieder zunächst bevorrechtigt, um dann weiter der automatischen, RDS-gesteuerten Betriebsweise unterworfen zu werden.

## Patentansprüche

1. Verfahren zum übertragen digitaler Informationen innerhalb eines Rundfunksignals als Abstimmhilfe beim Rundfunkempfang, bei dem die digitalen Informationen eine Folge von einzelnen, den jeweiligen Sendern einer Senderkette zugeordneten oder auf diese jeweiligen Sender optimierten Listen alternativer Frequenzen enthalten, **dadurch gekennzeichnet**, daß bei Übertragung jeder Liste als Folge digitaler Blöcke mit jeweils zwei digitalen Informationen je Block in der Regel
a) im ersten Block jeder einzelnen Liste eine Information über die Anzahl der alternativen Frequenzen der jeweiligen Liste sowie die Betriebsfrequenz des der jeweiligen Liste zugeordneten Senders, und
b) in dem restlichen Blöcken jeder einzelnen Liste jeweils die Betriebsfrequenz des der jeweiligen Liste zugeordneten Senders sowie die alternative Frequenz
übertragen werden.

2. Verfahren nach Anspruch 1, **dadurch gekennzeichnet**, daß empfangsseitig die in dem ersten Block und/oder in den restlichen Blöcken jeder Liste übertragene Betriebsfrequenz zur Zuordnung der alternativen Frequenzen zu der betreffenden Senderkette im Sinne einer eindeutigen, störsicheren Adressierung benutzt wird.

3. Verfahren nach Anspruch 1 oder 2, **dadurch gekennzeichnet**, daß von den empfangenen alternativen Frequenzen aller Frequenzlisten nur diejenigen alternativen Frequenzen gespeichert und/oder für die Abstimmung verwendet werden, deren jeweils zugeordnete Betriebsfrequenz mit der momentan eingestellten Empfangsfrequenz des Rundfunkempfängers übereinstimmt.

4. Verfahren nach einem der Ansprüche 1 - 3, **dadurch gekennzeichnet**, daß in den restlichen Blöcken die Betriebsfrequenz der jeweiligen alternativen Frequenz vorangestellt oder nachgestellt ist.

5. Verfahren nach einem der Ansprüche 1 bis 4, **dadurch gekennzeichnet**, daß die empfangenen digitalen Informationen einer Fehlerkorrektur unterzogen werden und daß eine nach Maßgabe der fehlerkorrigierten digitalen Informationen erfolgende Adressierung der alternativen Frequenzen aufgrund der in oder zu jeder Liste - gegebenenfalls mehrfach - übertragenen Senderbetriebsfrequenz vorgenommen wird.

6. Verfahren nach Anspruch 5, **dadurch gekennzeichnet**, daß bei den empfangenen digitalen Informationen festgestellte Bitfehler zur Qualitätsbewertung allein oder zusätzlich zur Empfangsfeldstärke herangezogen werden.

7. Verfahren nach Anspruch 6, **dadurch gekennzeichnet**, daß die Bitfehler dahingehend zur Bewertung von Programmsignalverzerrungen herangezogen werden, daß
a) bei burstartig auftretenden Bitfehlern Störungen durch Mehrwegeempfang oder Interferenz vorliegen;
b) bei gleichförmig verteilten Fehlern Störungen durch Rauschen vorliegen;
c) der Grad aller Störungen aus der Blockfehlerrate des in Blöcken strukturierten RDS-Datensignals abgeleitet wird,
und wobei aus den für jede alternative Sendefrequenz sowie für die momentane Empfangsfrequenz ermittelten Bitfehlern folgende Auswahlentscheidungen abgeleitet werden:
d) falls alle überprüften Frequenzen im wesentlichen nur burstartig oder nur gleichförmig verteilte Bitfehler aufweisen, werden sie hinsichtlich ihrer Blockfehlerrate miteinander verglichen, wobei diejenige Frequenz mit der geringsten Blockfehlerrate für die Empfängerabstimmung selektiert wird;
e) falls die überprüften Frequenzen unterschiedliche Bitfehlerverteilungen aufweisen, werden zunächst diejenigen Frequenzen vorselektiert, welche im wesentlichen nur gleichförmig verteilte Bitfehler aufweisen - gegebenenfalls abhängig davon, daß bei diesen Frequenzen eine festgelegte, maximal zulässige Blockfehlerrate nicht überschritten wird -, und anschließend werden die vorselektierten Frequenzen hinsichtlich ihrer Blockfehlerrate miteinander verglichen, wobei diejenige vorselektierte Frequenz mit der geringsten Blockfehlerrate für die Empfängerabstimmung selektiert wird.

8. Verfahren nach einem der Ansprüche 1 bis 7, **dadurch gekennzeichnet**, daß empfangsseitig die den momentan bestmöglichen Empfang bietende alternative Frequenz dahingehend überprüft wird, ob sie eine akustisch akzeptable Wiedergabe ermöglicht, und daß für den Fall, daß die überprüfte alternative Frequenz nur eine akustisch verzerrte Wiedergabe ermöglicht, eine andere alternative Frequenz gewählt wird.

9. Verfahren mach Anspruch 8, **dadurch gekennzeichnet**, daß zur Wahl einer anderen alternativen Frequenz manuell einstellbare Mittel verwendet werden.

10. Verfahren nach Anspruch 8 oder 9, **dadurch gekennzeichnet**, daß zur Wahl einer anderen alternativen Frequenz von einem Signal einstellbare Mittel verwendet werden, wobei das genannte Signal - gegebenenfalls auch unterschiedlich gewichtet - sowohl aus dem Vergleich empfangener Feldstärken als auch aus dem Vergleich von den Feldstärken zugeordneten niederfrequenten Verzerrungen abgeleitet ist.

11. Verfahren nach einem der Ansprüche 1 bis 10, **dadurch gekennzeichnet**, daß empfangsseitig die alternativen Frequenzen durch Auswerten eines in dem digitalen RDS-Datensignal enthaltenen Codes für die Programm-Identifikation (PI-Code) festgestellt werden, wobei das Empfangsteil einen Sendersuchlauf durchführt und die PI-Codes der auf den einzelnen Senderfrequenzen empfangenen RDS-Datensignale dahingehend verglichen werden, daß gleiche PI-Codes diejenigen Frequenzen identifizieren, auf welchen dasselbe Programmsignal empfangbar ist.

## Claims

1. A process for the transfer of items of digital information within a broadcast signal as tuning aid in the broadcast reception, wherein the items of digital information contain a sequence of individual lists of alternative frequencies assigned to the respective transmitters of a chain of transmitters or optimized in respect of these respective transmitters, characterised in that in the transfer of each list as a sequence of digital blocks with in each case two items of digital information per block, generally
a) in the first block of each individual list an item of information relating to the number of the alternative frequencies of the respective list and the operating frequency of the transmitter assigned to the respective list and
b) in the remaining blocks of each individual list the respective operating frequency of the transmitter assigned to the respective list and the alternative frequency
are transferred.

2. A process as claimed in Claim 1, characterised in that at the receiving end the operating frequency transferred in the first block and/or in the remaining blocks of each list is used to assign the alternative frequencies to the respective chain of transmitters in terms of clearly defined, disturbance-free addressing.

3. A process as claimed in Claim 1 or 2, characterised in that of the received alternative frequencies of all the lists of frequencies, only those alternative frequencies whose respective assigned operating frequency is identical to the instantaneously set receiving frequency of the broadcast receiver are stored and/or used for the tuning.

4. A process as claimed in one of Claims 1 to 3, characterised in that in the remaining blocks the operating frequency precedes or follows the respective alternative frequency.

5. A process as claimed in one of Claims 1 to 4, characterised in that the received items of digital information are subjected to error correction and that an addressing of the alternative frequencies, carried out in accordance with the error-corrected items of digital information, is performed on the basis of the transmitter operating frequency transferred - optionally several times - in or with each list.

6. A process as claimed in Claim 5, characterised in that bit errors detected in the received items of digital information are used for quality evaluation alone or in addition to the receiving field strength.

7. A process as claimed in Claim 6, characterised in that the bit errors are used to evaluate programme signal distortions inasmuch as
a) disturbances due to multipath reception or interference are present in the case of bit errors occurring in the form of bursts;
b) disturbances due to noise are present in the case of uniformly distributed errors;
c) the degree of all the disturbances is deduced from the block error rate of the RDS (radio-data-system) data signal structured in blocks,
and wherein the following selection decisions are deduced from the bit errors determined for each alternative transmitting frequency and for the instantaneous receiving frequency:
d) if all the checked frequencies exhibit bit errors which substantially are distributed only in the form of bursts or only uniformly, they are compared with one another in respect of their block error rate, where the frequency with the lowest block error rate is selected for the receiver tuning;
e) if the checked frequencies exhibit different bit error distributions, initially those frequencies which exhibit substantially only uniformly distributed bit errors are preselected - optionally in dependence upon the fact that at these frequencies a specified, maximum permissible block error rate is not exceeded - whereupon the preselected frequencies are compared with one another in respect of their block error rate, where the preselected frequency with the lowest block error rate is selected for the receiver tuning.

8. A process as claimed in one of Claims 1 to 7, characterised in that at the receiving end the alternative frequency which offers the instantaneously best possible reception is checked to determine whether it permits an acoustically acceptable reproduction, and that in the event that the checked alternative frequency only permits an acoustically distorted reproduction, a different alternative frequency is selected.

9. A process as claimed in Claim 8, characterised in that manually adjustable means are used to select a different alternative frequency.

10. A process as claimed in Claim 8 or 9, characterised in that means adjustable by a signal are used to select a different alternative frequency, where the said signal - optionally also differently weighted - is derived both from the comparison of received field strengths and also from the comparison of low-frequency distortions assigned to the field strengths.

11. A process as claimed in one of Claims 1 to 10, characterised in that at the receiving end the alternative frequencies are determined by analyzing a code for the programme identification (PI code) contained in the digital RDS data signal, where the receiving end executes a transmitter search run and the PI codes of the RDS data signals received on the individual transmitter frequencies are compared with the effect that identical PI codes identify those frequencies on which the same programme signal can be received.

## Revendications

1. Procédé pour transmettre des informations numériques à l'intérieur d'un signal de radiodiffusion comme auxiliaire d'accord lors de la réception radiophonique, dans lequel les informations numériques contiennent une séquence de différentes fréquences alternatives affectées aux émetteurs respectifs d'une chaîne d'émetteurs ou optimalisées sur ces émetteurs respectifs, **caractérisé en ce** que, lors de la transmission de chaque liste comme séquence de blocs numériques avec respectivement deux informations numériques par bloc en règle générale
a) dans le premier bloc de chaque liste individuelle une information sur le nombre des fréquences alternatives de la liste respective ainsi que la fréquence de service de l'émetteur affecté à la liste respective et
b) dans les blocs qui restent de chaque liste individuelle respectivement la fréquence de service de l'émetteur affecté à la liste respective ainsi que la fréquence alternative sont transmises.

2. Procédé selon la revendication 1, **caractérisé en ce** que, côté réception, la fréquence de service transmise dans le premier bloc et/ou dans les blocs qui restent de chaque liste est utilisée pour l'affectation des fréquences alternatives à la chaîne d'émetteurs concernée dans l'esprit d'un adressage univoque résistant aux perturbations.

3. Procédé selon la revendication 1 ou 2, **caractérisé en ce** que, parmi les fréquences alternatives reçues de toutes les listes de fréquences, seules les fréquences alternatives dont la fréquence de service qui leur est respectivement affectée coïncide avec la fréquence de réception du récepteur de radiodiffusion réglée momentanément sont mémorisées et/ou utilisées pour l'accord.

4. Procédé selon l'une des revendications 1 à 3, **caractérisé en ce** que dans les blocs qui restent la fréquence de service est soit placée devant, soit derrière la fréquence alternative respective.

5. Procédé selon l'une des revendications 1 à 4, **caractérisé en ce** que les informations numériques reçues sont soumises à une correction d'erreurs et qu'un adressage des fréquences alternatives, qui se fait au fur et à mesure des informations numériques dont les erreurs sont corrigées, est effectué en raison de la fréquence de service de l'émetteur qui est transmise - le cas échéant plusieurs fois - dans ou pour chaque liste.

6. Procédé selon la revendication 5, **caractérisé en ce** que des erreurs de bit constatées dans les informations numériques reçues sont utilisées pour l'évaluation de la qualité seulement ou en plus de l'intensité du champ de réception.

7. Procédé selon la revendication 6, **caractérisé en ce** que les erreurs de bits sont utilisées pour évaluer les distorsions de signal de programme de telle manière que
a) pour des erreurs de bits qui apparaissent de type salve, il y a des perturbations dûes à la réception à plusieurs voies ou à l'interférence ;
b) pour des erreurs réparties uniformément, il y a des perturbations dûes au bruit ;
c) le degré de toutes les perturbations est dérivé du taux d'erreurs de blocs du signal de données SDR structuré en blocs,
et les décisions de sélection suivantes étant dérivées des erreurs de bits détectées pour chaque fréquence d'émission alternative ainsi que pour la fréquence de réception momentanée :
d) au cas où toutes les fréquences vérifiées ne présentent essentiellement que des erreurs de bits de type salve ou que des erreurs de bits réparties uniformément, elles sont comparées l'une à l'autre pour ce qui est de leur taux d'erreurs de blocs, la fréquence avec le plus faible taux d'erreurs de bloc étant sélectionnée pour l'accord du récepteur ;
e) au cas où les fréquences vérifiées présentent différentes répartitions d'erreurs de bits, les fréquences qui présentent essentiellement uniquement des erreurs de bits réparties uniformément sont tout d'abord présélectionnées - le cas échéant, en fonction du fait que, pour ces fréquences, un taux d'erreurs de bloc maximal admissible fixé n'est pas dépassé - et ensuite les fréquences présélectionnées sont comparées l'une à l'autre pour ce qui est de leur taux d'erreurs de blocs, la fréquence présélectionnée avec le plus faible taux d'erreurs de bloc étant sélectionnée pour l'accord du récepteur.

8. Procédé selon l'une des revendications 1 à 7, **caractérisé en ce** que, côté réception, la fréquence alternative qui offre la meilleure réception possible momentanément est vérifiée pour voir si elle permet une restitution acceptable acoustiquement et que, pour le cas où la fréquence alternative vérifiée ne permet qu'une restitution déformée acoustiquement, une autre fréquence alternative est sélectionnée.

9. Procédé selon la revendication 8, **caractérisé en ce** que des moyens réglables manuellement sont utilisés pour sélectionner une autre fréquence alternative.

10. Procédé selon la revendication 8 ou 9, **caractérisé en ce** que des moyens réglables par un signal sont utilisés pour sélectionner une autre fréquence alternative, le signal mentionné - le cas échéant également pondéré différemment - étant dérivé aussi bien de la comparaison des intensités de champ reçues que de la comparaison des distorsions à basse fréquence affectées aux intensités de champ.

11. Procédé selon l'une des revendications 1 à 10, **caractérisé en ce** que, côté réception, les fréquences alternatives sont constatées par évaluation d'un code contenu dans le signal de données numériques SDR pour l'identification du programme (code IP), la partie réception effectuant une recherche d'émetteurs et comparant les codes IP des signaux de données SDR reçus sur les différentes fréquences des émetteurs de telle manière que les mêmes codes IP identifient les fréquences sur lesquelles le même signal de programme peut être reçu.
